# EUROPÄISCHE PATENTSCHRIFT

(11) **EP 0 504 477 B1**
(45) Veröffentlichungstag und Bekanntmachung des Hinweises auf die Patenterteilung: **29.12.1997**
(21) Anmeldenummer: 91118309.3
(22) Anmeldetag: 28.10.1991
(51) Int. Cl.: H01J 37/34

(54) **Vorrichtung zum Beschichten eines Substrats**
Substrate coating device
Dispositif de revêtement d'un substrat

(30) Priorität: 20.03.1991 DE 4109018
(43) Veröffentlichungstag der Anmeldung: 23.09.1992
(73) Patentinhaber: Balzers und Leybold Deutschland Holding Aktiengesellschaft, 63450 Hanau (DE)
(72) Erfinder: Latz, Rudolf, Dr., W-6054 Rodgau 2 (DE)

(56) Entgegenhaltungen:
- EP-A- 0 254 168
- EP-A- 0 416 241
- PATENT ABSTRACTS OF JAPAN vol. 13, no. 208 (C-596)16. Mai 1989

## Beschreibung

Die Erfindung betrifft eine Vorrichtung zum Beschichten eines Substrats, vorzugsweise mit Aluminiumoxid, mit einer Gleichstrom- und/oder einer Wechselstromquelle, die an eine in einer evakuierbaren Beschichtungskammer angeordnete Elektrode angeschlossen ist, die elektrisch mit einem Target in Verbindung steht, das zerstäubt wird und dessen zerstäubte Teilchen sich auf dem Substrat, beispielsweise einem Kunststoffteil, niederschlagen, wobei in die Beschichtungskammer ein Prozeßgas einbringbar ist und wobei toroidförmige Magnetfelder durch das Target hindurchgreifen, deren Feldlinien im Bereich der Magnetpole aus der Oberfläche des Targets austreten, wobei das Target zwei zueinander parallele, im wesentlichen längliche, parallelepide Teilstücke aufweist, deren Enden über zwei bogenförmige Targetpartien verbunden sind und mit diesen zusammen ein ringförmiges bzw. ovales Target bilden.

Es ist eine Kathodenzerstäubungsvorrichtung bekannt (DE-A 27 07 144; Sloan Technology Corp.), mit einer eine zu zerstäubende Fläche aufweisenden Kathode, einer Magneteinrichtung nahe der Kathode und an der der zu zerstäubenden Fläche gegenüberliegenden Seite zur Erzeugung magnetischer Kraftlinien, von denen wenigstens einige in die zu zerstäubende Fläche eintreten und aus ihr wieder heraustreten, und zwar an Schnittpunkten, die voneinander im Abstand liegen, zwischen denen die Kraftlinien kontinuierlich bogenförmige Segmente im Abstand von der zu zerstäubenden Fläche bilden, wobei letztere - zusammen mit den Kraftlinien - eine Begrenzung für einen geschlossenen Bereich bildet, wodurch ein tunnelförmiger Bereich gebildet wird, der über einem dadurch definierten Pfad auf der zu zerstäubenden Fläche liegt, wobei geladene Teilchen die Neigung zeigen, im tunnelförmigen Bereich zurückgehalten zu werden und sich entlang diesem zu bewegen, sowie mit einer Anode in Nachbarschaft zur Kathode und mit einem Anschluß der Kathode und der Anode an eine Quelle elektrischen Potentials, wobei wenigstens die zu zerstäubende Fläche innerhalb eines evakuierbaren Behälters liegt.

Bei dieser Vorrichtung ist eine Bewegungseinrichtung zur Herstellung einer Relativbewegung zwischen dem magnetischen Feld und der zu zerstäubenden Oberfläche unter Beibehaltung ihrer räumlichen Nachbarschaft vorgesehen, wobei der erwähnte Pfad die zu zerstäubende Fläche überstreicht, und zwar in einem Flächenbereich, der größer ist als der vom ruhenden Pfad eingenommene Flächenbereich.

Weiterhin ist eine Anordnung zum Beschichten eines Substrats mit Dielektrika bekannt (DE-A-38 21 207; Leybold AG), die eine Gleichstromquelle aufweist, die mit einer Elektrode verbunden ist, die elektrisch mit einem Target in Verbindung steht, das zerstäubt wird und dessen zerstäubte Teilchen mit einem zugeführten Stoff eine Verbindung eingehen, die sich auf dem Substrat niederschlägt, wobei toroidförmige Magnetfelder durch das Target hindurchgreifen, deren Feldlinien im Bereich der Magnetpole aus der Oberfläche des Targets austreten. Bei dieser Anordnung ist eine Wechselstromquelle vorgesehen, deren Ausgangsspannung der Gleichspannung der Gleichstromquelle überlagert ist, wobei die elektrische Leistung der Wechselstromquelle, die der Elektrode zugeführt wird, 5 % bis 25 % der von der Gleichstromquelle der Elektrode zugeführten Leistung entspricht.

Bekannt ist auch eine Zerstäubungskathode mit einer Dunkelraumabschirmung für Vakuumbeschichtungsanlagen (EP-A-0 254 168) mit einem metallischen Kathodengrundkörper und mit einem auf diesem durch Bonden befestigten Target, das mindestens teilweise, insbesondere an seiner Oberfläche, aus einem nicht metallischen Werkstoff besteht, wobei eine zwischen Kathodengrundkörper und Target gebildete, mit Bondmaterial gefüllte Nahtstelle an einem nicht der Glimmentladung ausgesetzen Ort angeordnet ist, wobei die Nahtstelle auf dem gesamten Umfang des nicht-metallischen Targets durch einen metallischen Rahmen abgedeckt ist, der auf Kathodenpotential liegt und gegenüber dem Target eine mit Bondmaterial gefüllte Trennfuge zwischen metallischem und nichtmetallischem Material bildet.

Schließlich ist bereits in einer älteren Patentanmeldung (EP-A-0 416 241) eine Vorrichtung zum Beschichten eines Substrats vorgeschlagen worden, die mit einer Gleichstrom-und/oder einer Wechselstromquelle ausgestattet ist, die an eine in einer evakuierbaren Beschichtungskammer angeordneten Elektrode angeschlossen ist, die elektrisch mit einem Target in Verbindung steht, das zerstäubt wird und dessen zerstäubte Teilchen sich auf dem Substrat niederschlagen, wobei in die Beschichtungskammer ein Prozeßgas einbringbar ist und wobei Magnetfelder durch das Target hindurchgreifen, deren Feldlinien im Bereich der Magnetpole aus der Oberfläche des Targets austreten.

Bei dieser Vorrichtung weist das Target zwei im wesentlichen längliche, parallelepipede Teilstücke auf, wobei die Enden der beiden Teilstücke jeweils mit Hilfe von zwei bogenförmigen Targetpartien verbunden sind und so zusammen ein ringförmiges oder ovales Target bilden.

Das Target ist bei dieser Vorrichtung von einer Dunkelraumabschirmung umschlossen, deren dem Substrat zugewandter umlaufender Rand oder Stirnfläche geringfügig gegenüber der Vorderfläche des Targets zurückversetzt ist, wobei die in einer Kathodenwanne angeordnete, auf einem Joch gehaltene Magnetanordnung aus einer mittleren, sich in Targetlängsrichtung ersteckenden Reihe von schmalen Magneten, einer weiteren an der Randpartie des Jochs angeordneten endlosen Reihe von schmalen Magneten und zwei Rundmagneten gebildet ist, wobei sich jeweils einer der Rundmagnete an jedem Ende der mittleren Reihe von Magneten befindet.

Der vorliegenden Erfindung liegt nun die Aufgabe zugrunde, eine Anordnung zum stabilen Betrieb von komplizierten, reaktiven Sputterprozessen zu schaffen. Insbesondere sollen Verbindungsschichten, wie beispielsweise Al₂O₃, SiO₂, Si₃N₄, ITO, TiO₂, Ta₂O₅ mit hoher Beschichtungsrate und Qualität herstellbar sein, wobei insbesondere das den Prozeß stark beeinträchtigende Arcing vermieden werden soll.

Diese Aufgabe wird erfindungsgemäß dadurch gelöst, daß das Target von einer Dunkelraumabschirmung umschlossen ist, dessen dem Substrat zugewandter umlaufender Rand die unmittelbar mit dem Target verbundene Kathodenwanne übergreift, derart, daß der Rand einen schmalen kreisförmigen Bereich der dem Substrat zugekehrten Stirnfläche der Kathodenwanne abdeckt, wobei sich der Rand jedoch in einem isolierenden Abstand zur Kathodenwanne erstreckt und der Rand der geerdeten Dunkelraumabschirmung mit seiner dem Substrat zugekehrten Stirnfläche um ein geringes Maß hinter der dem Substrat zugekehrten Targetfläche zurückversetzt ist, wobei die in einer Kathodenwanne angeordnete, auf einem Joch gehaltene Magnetanordnung aus einer mittleren, sich in Targetlängsrichtung erstreckenden Reihe von schmalen Magneten und einer weiteren, an der Randpartie des Jochs angeordneten endlosen Reihe von schmalen Magneten gebildet ist.

Die Erfindung läßt die verschiedensten Ausführungsmöglichkeiten zu; eine davon ist in der anhängenden Zeichnung schematisch näher dargestellt, die eine Sputteranlage mit einem zentral zu einem ovalen Ring ausgeformten ersten Target angeordneten zweiten Target zeigt.

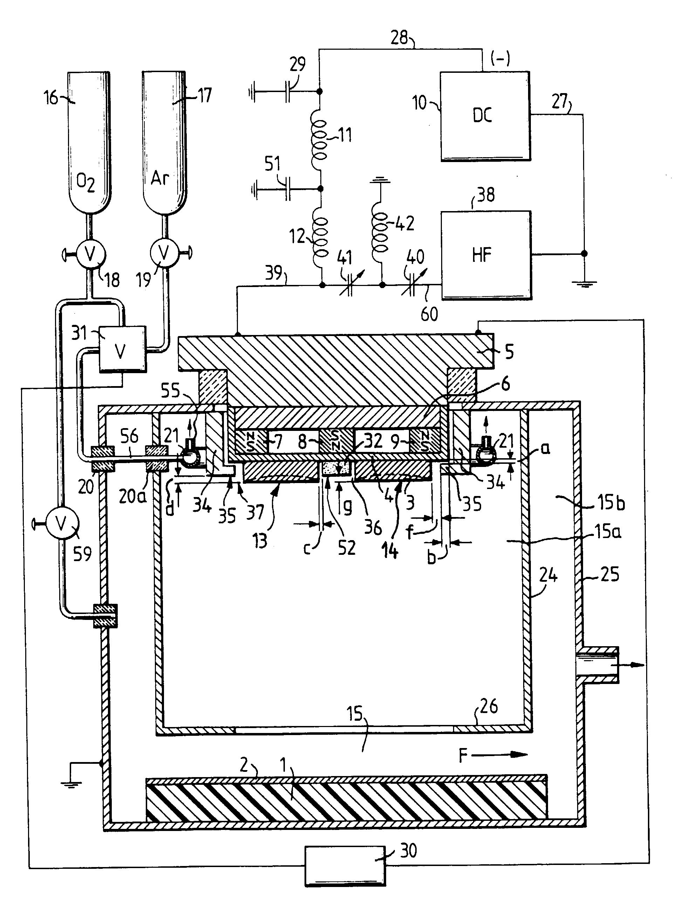

In der Zeichnung ist ein Substrat 1 dargestellt, das mit einer dünnen Metallschicht 2 versehen werden soll. Diesem Substrat 1 liegt ein Target 3 gegenüber, das zu zerstäuben ist. Das ringförmige Target 3, das bereits ein stabförmiges Target umschließt, steht über einem im Schnitt U-förmigen Element 4 (einer sogenannten Kathodenwanne) mit einer Elektrode 5 in Verbindung, die auf einem Joch 6 ruht, das zwischen sich und dem Element 4 drei Reihen von Dauermagneten 7, 8, 9 einschließt. Die auf das Target 3 gerichteten Polaritäten der Pole der Dauermagnetreihen 7, 8, 9 wechseln sich ab, so daß jeweils die Südpole der äußeren Dauermagnetreihe 7, 9 mit dem Nordpol der mittleren Dauermagnetreihe 8 ein etwa kreisförmiges Magnetfeld durch das Target 3 bewirken. Dieses Magnetfeld verdichtet das Plasma vor dem Target 3, so daß es dort, wo die Magnetfelder das Maximum besitzen, seine größte Dichte hat. Die Ionen im Plasma werden durch ein elektrisches Feld beschleunigt, das sich aufgrund einer Gleichspannung aufbaut, die von einer Gleichstromquelle 10 angegeben wird. Diese Gleichstromquelle 10 ist mit ihrem negativen Pol über zwei Induktivitäten 11, 12 und die elektrische Leitung 39 mit der Elektrode 5 verbunden. Das elektrische Feld steht senkrecht auf der Oberfläche des Targets 3 und beschleunigt die positiven Ionen des Plasmas in Richtung auf dieses Target 3. Hierdurch werden mehr oder weniger viele Atome oder Partikel aus dem Target 3 herausgeschlagen , und zwar insbesondere aus den strichliert eingezeichneten Gebieten (bzw. Sputtergräben) 13, 14, wo die horizontale Komponente des Magnetfeldes ihr Maximum hat.

Die zerstäubten Atome oder Partikel wandern in Richtung auf das Substrat 1 zu, wo sie sich als dünne Schicht 2 niederschlagen.

Die aus dem Target 3 herausgeschlagenen Metallpartikel reagieren in einem Raum 15 auf der Substratoberfläche mit bestimmten Gasen, die aus Gasbehältern 16, 17 über Ventile 18, 19, 31, 59 und einen Einlaßstutzen 20, 20a mit einer an diesen angeschlossenen Ringleitung 21 mit Düsen 55 mittels Gaszuführungsleitung 56 in diesen Raum 15a geleitet werden. Dieser Raum 15a wird durch zwei Behälter 24, 25 gebildet, von denen der eine Behälter 25 das Substrat 1 mitumfaßt, während der andere Behälter 24 vor dem Substrat 1 endet und eine Blende 26 bildet. Beide Behälter 24, 25 und damit auch das Substrat 1, das auf dem Boden des Behälters 25 ruht, liegen elektrisch auf Masse. An Masse liegt auch der zweite Anschluß 27 der Gleichstromquelle 10, deren erster Anschluß 28 außer an die Induktivitäten 11, 12 auch noch an Kondensatoren 29, 51 angeschlossen ist, die ihrerseits an Masse liegen.

Das Gas wird zweckmäßigerweise über ein die Kathode 5 umgebendes Gasverteilungssystem bzw. eine Ringleitung 21 mit Düsen 55 dem zweiten Behälter 24 zugeführt und gelangt darüber hinaus auch in den Zwischenraum 15b zwischen dem ersten und dem zweiten Behälter 24, 25.

Für die Steuerung der dargestellten Anordnung kann ein Prozeßrechner 30 vorgesehen werden, der Meßdaten verarbeitet und Steuerungsbefehle abgibt. In diesem Prozeßrechner 30 können beispielsweise die Werte des gemessenen Partialdrucks in der Prozeßkammer 25 eingegeben werden.

Aufgrund dieser und anderer Daten kann er zum Beispiel den Gasfluß über das Piezoventil 31 regeln und die Spannung an der Kathode 5 einstellen. Der Prozeßrechner 30 ist auch in der Lage, alle anderen Variablen, zum Beispiel Kathodenstrom und magnetische Feldstärke, zu regeln. Da derartige Prozeßrechner bekannt sind, wird auf eine Beschreibung ihres Aufbaus verzichtet.

Wie die Zeichnung zeigt, sind sowohl das U-förmige Element bzw. die Kathodenwanne 4 als auch das ringförmige Target 3 mit dem zentralen Target 32 von einer Dunkelfeldabschirmung 34 umschlossen, dessen substratseitiger umlaufender Rand 35 um das Maß b über den Randbereich der Kathodenwanne 4 hinausragt. Weiterhin befindet sich zwischen dem zentralen Target 32 und den radial inneren Flächen des Targets 3 ein Ringspalt 36 (c = 1 mm) und ebenso ein Ringspalt 37 zwischen der radial äußeren Fläche des Targets 3 und dem Rand der Dunkelfeldabschirmung 34 (f = 2 mm). Insbesondere durch den den radial außenliegenden Rand der Targetwanne 4 übergreifenden Teil der Dunkelfeldabschirmung 34 wird das unerwünschte "Arcing" vermieden (d. h. das unerwünschte Sichbilden von Lichtbögen-Uberschlägen). Schließlich sei noch erwähnt, daß auch die substratseitige Stirnfläche 52 des stabförmigen zentralen Targets 32 gegenüber der kreisringförmigen Stirnfläche 13, 14 des Targets 3 um ein geringes Maß (g = 1 mm) zurückversetzt ist.

Neben der DC-Stromquelle 10 ist außerdem eine HF-Stromquelle 38 an die Stromversorgungsleitung 39 bzw. 60 mit zwischengeschalteten Kondensatoren 40, 41 und einer Induktivität 42 vorgesehen, die auch die Einspeisung eines Wechselstroms in die Elektrode 5 ermöglicht.

Bei der beschriebenen Vorrichtung ist gewährleistet, daß eine reaktive Gasentladung in einer Argon-Reaktivgasatmosphäre vor der Magnetronkathode 5 mit einem Target 3 stabil brennt. Es kann sich dabei entweder um eine Gleichspannungsentladung, eine Hochfrequenzentladung oder eine Überlagerung von beiden handeln.

Das Target 3 ist (was aus der Zeichnung nicht näher ersichtlich ist) als Langtarget (Rechtecktarget) ausgeformt, dessen Enden bogenförmig durch Kreisringstücke abgerundet sind; d. h. daß das Langtarget im Grundriß die Form eines Ovals hat (mit parallel zueinander angeordneten länglichen parallelepipeden Seitenstücken).

Diese Konfiguration ist insbesondere für eine reine DC-Entladung empfehlenswert. Das so geformte Target kann entweder auf rechteckige Standardkathodenwannen oder auf speziell mit Rundbögen hergestellte Kathodenwannen 4 aufgebracht werden.

Bei einer besonderen Ausführungsform ist das Magnetfeld derart geformt, daß der sputternde Bereich auf dem Target möglichst groß ist. Speziell für Langkathoden mit Rundbogentargets empfiehlt sich ein Magnetfeld, das von zwei Rundmagneten unterstützt wird, die an den einander diametral gegenüberliegenden Enden der mittleren Magnetreihe 8 angeordnet sind.

Die Magnetanordnung einer bevorzugten Ausführungsform zeichnet sich durch folgende Besonderheiten aus:
a) Die gewählten Magnete 7, 8, 9 sind sehr schmal (z. B. c = 5 mm) und haben eine hohe Magnetfeldstärke (Vacudym-Magnete).
b) An beiden Enden der Mittelmagnetreihe 8 sitzen zwei Rundmagnete von besonderer Größe und Stärke, so daß das Targetmaterial bei üblichen Entladespannungen bis zum Rande abgesputtert wird.

Bei einer weiteren Ausführungsform der Vorrichtung ist das Target zusammen mit dem U-förmigen Joch bzw. der Kathodenwanne auf der Elektrode 5 angeordnet, während die Dauermagnete bzw. Magnetreihen mit ihrem Joch mit dem Zapfen eines Kurbeltriebs gekoppelt sind (nicht näher dargestellt), der seinerseits von einer Welle antreibbar ist und über den das Joch in eine oszillierende Bewegung versetzbar ist, wobei diese Bewegungen von den Innenwänden der Kathodenwanne 4 begrenzt werden. Es ist klar, daß in diesem Falle die Abmessungen des Jochs so gewählt (kleiner) werden müssen, daß für eine oszillierende Bewegung ausreichend Platz in der Kathodenwanne verbleibt.

Bei Langkathoden ist es also möglich, bei Verwendung eines abgerundeten Targets und bei Verwendung der entsprechenden Magnetanordnung das Magnetfeld auf mindestens zweierlei Art so zu bewegen, daß selbst beim reaktiven Sputtern Belegungen an der Targetoberfläche vermieden werden, nämlich
a) durch eine seitliche Hin- und Herbewegung des gesamten Magnetjoches in der Kathodenwanne 4 und
b) durch eine gleichzeitige Bewegung des Magnetjochs in der Kathodenwanne 4 in deren Längsrichtung, so daß die Magnetanordnung sowohl in seitlicher als auch in Längsrichtung hin und her bewegt wird.

Die oben beschriebene Anordnung verhindert ebenfalls, daß sich beim reaktiven Sputtern an der Targetoberfläche isolierende Beläge bilden, durch die es zu Instabilitäten der Entladung kommen kann.

Die Vermeidung solcher Instabilitäten ist beim reaktiven Sputtern unbedingt notwendig, jedoch erfahrungsgemäß kaum unter Produktionsbedingungen zu erreichen.

Dies ist insbesondere bei einigen kritischen, reaktiven Sputterprozessen (wie z. B. die Prozesse zum Herstellen von Al₂O₃, SiO₂, Si₃N₄, ITO, TiO₂, Ta₂O₅) der Fall, insbesondere wenn hohe Sputterraten erwünscht sind.

### Bezugszeichenliste

- 1: Substrat
- 2: Schicht
- 3: Target
- 4: U-förmiges Element, Kathodenwanne
- 5: Elektrode
- 6: Joch
- 7: Dauermagnet
- 8: Dauermagnet
- 9: Dauermagnet
- 10: Gleichstromquelle
- 11: Induktivität
- 12: Induktivität
- 13: Targetfläche
- 14: Sputtergraben (Gebiet)
- 15, 15a, 15b: Raum, Beschichtungskammer
- 16: Gasbehälter
- 17: Gasbehälter
- 18: Ventil
- 19: Ventil
- 20, 20a: Einlaßstutzen
- 21: Ringleitung mit Düsen
- 22: Gaszuführungsleitung
- 23: Gaszuführungsleitung
- 24: Behälter
- 25: Behälter, Prozeßkammer
- 26: Blende
- 27: elektrischer Anschluß (Masse-Leitung)
- 28: elektrischer Anschluß
- 29: Kondensator
- 30: Prozeßrechner
- 31: Ventil, Piezoventil
- 32: zweites Target
- 33: Dunkelfeldabschirmung
- 34: Randbereich
- 35: Ringspalt
- 36: Ringspalt
- 37: HF-Stromquelle
- 38: Stromversorgungsleitung
- 39: Kondensator
- 40: Kondensator
- 41: Widerstand, Induktivität
- 42: Rohrstück
- 43: Ventil

## Patentansprüche

1. Vorrichtung zum Beschichten eines Substrats (1), vorzugsweise mit Aluminiumoxid, mit einer Gleichstrom- und/oder einer Wechselstromquelle (10 bzw. 38), die an eine in einer evakuierbaren Beschichtungskammer (15, 15a, 15b) angeordnete Elektrode (5) angeschlossen ist, die elektrisch mit einem Target (3, 32) in Verbindung steht, das zerstäubt wird und dessen zerstäubte Teilchen sich auf dem Substrat (1), beispielsweise einem Kunststoffteil, niederschlagen, wobei in die Beschichtungskammer (15, 15a, 15b) ein Prozeßgas einbringbar ist und wobei toroidförmige Magnetfelder durch das Target (3, 32) hindurchgreifen, deren Feldlinien im Bereich der Magnetpole (7, 8, 9) aus der Oberfläche des Targets austreten, wobei das Target (3) zwei zueinander parallele, im wesentlichen Längliche, parallelepipede Teilstücke aufweist, deren Enden über zwei bogenförmige Targetpartien verbunden sind und mit diesen zusammen ein ringförmiges bzw. ovales Target bilden, **dadurch gekennzeichnet,** daß das Target (3) von einer Dunkelraumabschirmung (34) umschlossen ist, dessen dem Substrat (1) zugewandter umlaufender Rand (35) eine unmittelbar mit dem Target (3) verbundene Kathodenwanne (4) übergreift, derart, daß der Rand (35) einen schmalen kreisringförmigen Bereich (b) der dem Substrat (1) zugekehrten Stirnfläche der Kathodenwanne (4) abdeckt, wobei sich der Rand (35) jedoch in einem isolierenden Abstand (a) zur Kathodenwanne (4) erstreckt und der Rand (35) der geerdeten Dunkelraumabschirmung (34) mit seiner dem Substrat (1) zugekehrten Stirnfläche um ein geringes Maß (d) hinter der dem Substrat (1) zugekehrten Targetfläche (13) zurückversetzt ist, wobei die in der Kathodenwanne (4) angeordnete, auf einem Joch (6) gehaltene Magnetanordnung aus einer mittleren, sich in Targetlängsrichtung erstreckenden Reihe von schmalen Magneten (8) und einer weiteren, an der Randpartie des Jochs (6) angeordneten, endlosen Reihe von schmalen Magneten (7, 9) gebildet ist.

## Claims

1. Device for coating a substrate (1), preferably with aluminium oxide, having a DC source (10) and/or an AC source (38) connected to an electrode (5) which is arranged in a coating chamber (15, 15a, 15b) that is capable of being evacuated and which is electrically connected to a target (3, 32) which is sputtered and the sputtered particles of which are deposited on the substrate (1), for instance a plastic moulding, whereby a process gas is capable of being introduced into the coating chamber (15, 15a, 15b) and whereby toroidal magnetic fields pass through the target (3, 32), the field lines of which magnetic fields emerge from the surface of the target in the region of the magnetic poles (7, 8, 9), whereby the target (3) comprises two substantially oblong parallelipipedal components which are parallel to one another, the ends of which are connected via two arcuate target portions and form together with the latter an annular or oval target,
characterised in that the target (3) is surrounded by a dark-space screen (34), the circumferential edge (35) of which facing the substrate (1) overlaps a cathode trough (4) that is directly connected to the target (3) in such a manner that the edge (35) covers up a narrow circular region (b) of the end face of the cathode trough (4) facing the substrate (1), whereby, however, the edge (35) extends subject to an insulating spacing (a) in relation to the cathode trough (4) and the edge (35) of the earthed dark-space screen (34) with its end face facing the substrate (1) is set back by a small extent (d) behind the target surface (13) facing the substrate (1), whereby the magnet arrangement that is arranged in the cathode trough (4) and held on a yoke (6) is formed from a central row of narrow magnets (8) extending in the longitudinal direction of the target and another endless row of narrow magnets (7, 9) arranged on the edge portion of the yoke (6).

## Revendications

1. Dispositif de revêtement d'un substrat (1), de préférence avec de l'oxyde d'aluminium, comportant une source de courant continu et/ou une source de courant alternatif (10 ou 38) qui est reliée à une électrode (5) disposée dans une chambre de revêtement (15, 15a, 15b) dans laquelle on peut faire le vidc, qui est électriquement rcliée à une cible (3, 32) qui se pulvérise et dont les particules pulvérisées précipitent sur le substrat (1), par exemple une pièce de plastique, dispositif dans le cas duquel on peut amener un gaz de processus dans la chambre de revêtement (15, 15a, 15b) et dans le cas duquel pénètrent à travers la cible (3, 32) des champs magnétiques de forme toroïdale dont les lignes de champ sortent de la surface de la cible au voisinage des pôles magnétiques (7, 8, 9), dans le cas duquel la cible (3) présente deux éléments partiels parallèles l'un à l'autre, sensiblcment longitudinaux, parallélépipédiques, dont les extrémités sont reliées par l'intermédiaire de deux parties de cible en forme d'arc et forment avec celles-ci une cible de forme annulaire ou ovale,
caractérisé par le fait que la cible (3) est enserrée par un écran à fond sombre (34) dont le bord périphérique (35) situé du côté du substrat (1) déborde au-delà d'une cuvette de cathode (4) directement reliée à la cible (3), de façon que le bord (35) recouvre une étroite zone annulaire (b) de la surface frontale, située du côté du substrat (1), de la cuvette de cathode (4), étant précisé que le bord (35) s'étend toutefois à une distance d'isolement (a) par rapport à la cuvette de cathode (4) et que le bord (35) de l'écran à fond noir (34), mis à la masse, est, par sa surface frontale située du côté du substrat (1), décalé d'une faible cote (d) derrière la surface de la cible (13) située du côté du substrat (1), étant précisé que l'agencement des aimants, disposé dans la cuvette de cathode (4), tenu sur une culasse (6), est formé d'une rangée médiane, s'étendant selon la direction longitudinale de la cible, d'aimants étroits (8) et d'une autre rangée, disposée, sans fin, sur la partie de bordure de la culasse (6), d'aimants étroits (7, 9).
